# EUROPEAN PATENT SPECIFICATION

(11) **EP 2 706 712 B1**
(45) Date of publication and mention of the grant of the patent: **07.06.2017**
(21) Application number: 12183643.1
(22) Date of filing: 10.09.2012
(51) Int. Cl.: H04L 25/03, G11C 7/02, H04B 3/14, G11C 7/10

(54) **Method and system for improving data transfer integrity**
Verfahren und System fur die Verbesserung der Integrität der Datenübertragung
Méthode et système pour améliorer l'integrité des données transferées

(43) Date of publication of application: 12.03.2014
(73) Proprietor: Technische Universität Darmstadt, 64285 Darmstadt (DE)
(72) Inventor: Yuan, Fang, 64283 Darmstadt (DE); Jaiswal, Ashok, 64295 Darmstadt (DE); Hofmann, Klaus, 64291 Darmstadt (DE)
(74) Representative: Stumpf, Peter

(56) References cited:
- EP-A1- 2 378 730
- US-A1- 2004 240 376

## Description

The invention relates to a method for improving the signal integrity of a data transfer line in a time synchronised data transfer system, wherein at least one equalizer unit is provided for said data transfer line. The invention also relates to an equalizer unit for a time synchronised data transfer system. Furthermore the invention relates to an electronic device comprising a synchronised data transfer system.
In nowadays digital electronics, data has to be transferred between various units frequently. The transfer of data not only has to be performed between different units (for example between different computers or workstations in a computer network or in a computer cluster), but also between subunits inside a single unit. As an example for the latter, computer busses that are used to transfer data between the CPU (central processing unit), the electronic memory (usually RAM = random access memory), a graphics card, a hard disk drive etc. can be mentioned. However, the necessity for a data transfer does not stop at this level, but even goes beyond.

As an example, even within a computer memory board or on the graphics card itself, a huge amount of data transfer has to be performed. As an example, nowadays computer memory systems are typically divided into a memory controller serving a plurality of memory chips using a 32 bit data bus (or an even wider data bus). Hence, a data transfer at an appropriate data transfer rate has to be provided for the communication between the respective memory controller chip and the memory chips themselves. Another example is the communication between GPUs (graphic processing units) and the graphic data memory chips (typically all arranged on a computer graphics card or a computer video card).

Depending on the devices to be coupled together (i.e. depending on the actual application) and particularly based on economic considerations, an appropriate maximum data transfer rate has to be chosen. As a rule of thumb, a good compromise between a data rate that is as high as possible (for performance reasons) and a resulting data transfer device that is as cheap as possible (and hence typically slow with respect to maximum data transmission rate) has to be chosen. A good compromise will be typically based on the application. While a data transfer between two computers with a data transfer rate of 10 Mbit/sec may be more than enough for standard applications, such a data transfer rate will be way too low for a data transfer between a CPU and an electronic memory unit and/or within an electronic memory module.

In general, data transfer protocols can be divided into synchronous data transfer protocols and asynchronous data transfer protocols.

Roughly speaking, asynchronous data transfer protocols are typically cheaper to implement and have the advantage that different units with a strongly varying design and performance can be connected to each other. The big drawback of asynchronous computer protocols is their comparatively slow speed which is in part based on the amount of a data transfer that is required for the handshake protocol. The big advantage is the typically comparatively low hardware requirements, and that typically comparatively few cables have to be used for interconnecting the respective units with each other. A typical example for asynchronous data transfer protocols are the Ethernet, LAN (local area networks) and/or DSL connections (DSL = digital subscriber line). It has to be noted that even here usually a synchronisation is done. However, if such a synchronisation is performed, this is usually done on a frame level, and not on a clocking signal level.

On the other side, there are the synchronous data transfer protocols. Typically, when using synchronous data transfer protocols the resulting data transfer rates are significantly higher as compared to asynchronous data transfer methods. This is of course a big advantage. As a drawback, the hardware requirements are higher. In particular, quite often several clocking signals have to be provided and/or usually a comparatively high number of connecting wires are used and/or very high frequencies have to be used for data transfer. Furthermore, the units that are connected with each other by a synchronous data connection usually have to have a somewhat similar performance. A typical example for the use of synchronous data transfer methods are computer busses within a computer and/or the data transfer that is performed between a memory controller and the memory storage chips and/or between a GPU and graphic memory chips.

To increase the data transfer rate of synchronous data transfer protocols even further without unduly increasing the power consumption and/or the cost for the electronic devices needed, different clocking speeds have been used for the interconnecting lines between two electronic devices to be connected to each other. For illustrative purposes, let's have a look at a data transfer that is effectuated between a memory controller (serving as a master) and the memory storage chips (working as slaves) in a GDDR5-memory system. Here, as an example, a main clocking signal of 1 GHz (basic frequency) is used. This frequency is used for transmitting commands and addresses over a respective data transfer line. However, the "real" data transfer (i.e. the data that is read out of and/or that is written into the indicated address) is transferred based on a second clocking signal (the write clocking signal or forward clocking signal, typically abbreviated as WCK) where the second clocking signal typically runs at a frequency, twice as high as the main clocking signal (typically abbreviated as CK or CLK). Moreover, a data bit is usually not only transmitted on a rising flank of the WCK signal, but also on a falling flank of the WCK signal. This way, a data transfer rate of 4 Gbit/sec can be realised (typically transferred on a dedicated data transfer line (usually abbreviated as DATA or DQ).

Transmitting data at such high frequencies raises various problems. In particular, signals that are transmitted on the individual lines fall clearly in the radio frequency range. The individual lines act as small transmitting and receiving antennas, so that the respective signal is in part transferred to other lines as well. This effect is generally known as the cross talk effect (X talk). Furthermore, the individual lines show a certain inductance and electric capacitance, which leads to a certain signal degradation on the transmitting line. This is known as the intersymbol interference (ISI). To be able to connect electronic components of various manufacturers with each other, certain quality standards that have to be obeyed by the respective manufacturer have been defined. To continue with the example of a GDDR5-memory system, such standards have been defined in the so-called JEDEC-standard. However, obeying such standards requires a certain quality level of the respective electronic components. This results in a certain minimum production cost. However, since the price of memory chips has a significant impact on the overall price of electronic devices, a further reduction of prices for electronic memory is desired. Furthermore, it would be desirable to increase the data transfer rates, preferably without increasing the price for the respective components (at least not linearly).

A method for improving the performance of an interconnection between integrated circuit devices has been suggested in United States patent application US 2011/0310949 A1. Here, it is suggested to provide a signalling system with a pre-emphasising transmitter and an equalizing receiver that are coupled to one another via a high-speed signal path. The receiver measures the quality of data conveyed from the transmitter. A controller uses this information to adaptively establish appropriate transmit pre-emphasis and receive equalization settings, e.g. to select the lowest power setting for which the signalling system provides some minimum communication bandwidth without exceeding a desired bit-error rate. However, this approach requires comparatively elaborate electronics on both sides of the signal path. This will increase the overall cost of the resulting electronic device significantly. This is particularly the case, because a typically significant number of slave-chips has to be equipped with complex electronics. Additional cost and power consumption comes from the necessary controller unit used for controlling the signalling systems components. Another problem is that the control of the pre-emphasising transmitter and the equalizing receiver is based on the bit-error rate of the signals transmitted via the high-speed signal path. Therefore, depending on the error detection system used, it can take a considerable time until an acceptable setting can be reached (if at all). Another major problem is that the system, described in US 2011/0310949 A1 is not compatible with present memory systems (in particular with DDR memory systems, in particular with GDDR5 memory systems). This poses a major obstacle for the use of this system.

Therefore, there is a significant need for an improved method for improving the signal integrity of a data transfer line in a time synchronised data transfer system as well as for improved equalizer units and/or digital devices comprising a time synchronised data transfer system - see also US 2004/240376. It is therefore the object of the invention to provide a method for improving the signal integrity of a data transfer line in a time synchronised data transfer system that is improved over presently known methods for improving the signal integrity of such a data transfer line. It is another object of the invention to propose an equalizer unit that is improved over presently known equalizer units. It is yet another object of the invention to provide an electronic device that comprises a synchronised data transfer system that is improved over presently known electronic devices.

The invention solves these objects.

It is suggested to perform a method for improving the signal integrity of a data transfer line in a time synchronised data transfer system, wherein at least one equalizer unit is provided for said data transfer line and wherein a training phase, comprising at least one training cycle for adjustment of the settings of said at least one equalizer unit, is used in a way that said adjustment of the settings of said at least one equalizer unit is at least in part based on transmitting test data via said data transfer line to be trained and that said test data is compared with comparative data that is transferred via a safe transmission channel. Training phases are frequently used in time synchronised data transfer system. During such a training phase, certain settings of the transmitter and/or the receiver part of the data transfer system are optimised to reduce the error rate, to reduce the power consumption and/or to increase the achievable data transfer rate. So far, however, training phases usually have been restricted to correct for a phase difference between the various components. Other adjustments have hardly been proposed in the state of the art (if at all). One of the few examples that equalizers are used for data transmissions and that the settings of the equalizers are adjusted is described in US 2011/0310949 A1. In this publication, the use and a possible setup of an equalizer for a data transfer line is described. However, for the present invention a wide variety of different equalizers can be employed. Just to name another example, in US 5,228,058 A another possible equalizer is described. The equalizer unit can be provided at any side of the data transfer line. In other words, both transmit equalizers and/or receive equalizers can be used in the present context. The data transfer line is preferably a data transfer line that is provided for data transfer. In the example of a GDDR5-chip, this would be preferably the data transfer line (usually DQ-line) on which the "normal" data is transmitted. Such a data transfer line is usually operating at a comparatively high data transfer rate, in particular at a higher clocking speed as compared to (at least some of) the other lines. As an example, the DQ-line is usually operated at double or quadruple speed as opposed to the other lines. Of course, one has to admit that at least some of the other lines transmit data as well, for example a memory address line (usually referred to as ADDR) transfers some data as well, namely the address information, even with presently commercially available chips. However, here the data transfer is usually performed at a lower frequency as compared to the "real data channel" (usually at standard clocking speed). One aspect of the invention lies in the idea to use "real" data (i.e. test data) for adjusting the settings of the at least one equalizer unit. This data is transferred on the data transfer line, preferably at "usual" data transfer conditions. In particular, full data transfer rate is employed for transmitting the test data. Therefore, a "realistic" picture of the current transmission characteristics is obtained and hence a better adjustment can be performed. Another aspect of the invention lies in the idea to not rely on any error detection algorithm or the like. This can be problematic, since such algorithms can result in wrong or ambiguous results (in particular if the overhead is minimised) or can alternatively result in a significant overhead (in particular if the probabilities of errors have to be minimised). According to the present suggestion, the test data is compared with comparative data that is transferred via a safe transmission channel. Usually, the comparative data is (at least in part) the same as the test data. This way usually improved results can be achieved. The data (test data and/or comparative data) preferably resembles "usually transmitted data". For example, typically transmitted bit patterns can be used for this. This will usually result in an improvement over standard repetitive patterns (like a continuous alternating stream of 0's and 1's and/or a continuous series of (sets of) identical bites. To obtain "realistic data", an advantageous dataset can be stored or a pseudorandom pattern can be transmitted. The safe transmission channel can be generated in a plethora of ways. As an example, the data transmission can be performed during manufacture of the respective devices so that "standard datasets" (in particular according to a certain standard) are stored and compared during a booting sequence. However, it is also possible to perform a "real data transmission" between the components on both sides of the data transfer line. The safe transmission can be employed, for example, by temporarily using a "safer error correction algorithm", a different data line, a different clocking speed and/or different data transmission protocols that are particularly safe. Safe in the context of this description usually means that very few errors occur during the transmission. In particular, few errors, as compared to the error rate of test data on the test data line, should occur during transmission. However, it should be mentioned that even some errors during transmission on the safe transmission channel usually do not pose a particular problem. Usually, an error "once in a while" will be considered to be a "not yet optimum setting of the equalizer", and hence the training phase will be somewhat prolonged.

In general, any kind of equalizer unit can be used, employing essentially any thinkable modification of the transmitted data. Preferably, however, the at least one equalizer unit alters the voltage level and/or the signal shape and/or the duty cycle of the data signal on said data transfer line. These modifications will usually have the greatest impact when trying to reduce the error rate on the data transfer line. Therefore, if these modifications are performed, usually the most efficient equalizer unit can be realised (resulting in a good compromise between best signal alteration and still simple setup of the equalizer unit).

Preferably, the method is employed in a way that said test data and/or said comparative data is at least at times stored, preferably temporarily stored. Storing can be done during the production of the respective components for the components of one or both sides (in the case of memory systems for slave components and/or for master components). For this, a certain standard data pattern can be used (which should be defined according to a certain standard). Additionally or alternatively a temporal storage is possible as well. This way, transmission of test data and/or comparative data at different transmission speeds and/or via different transmission lines (usually showing different delays) can be performed and still such data can be compared. Furthermore, when data is temporarily stored, a transmission of test data and comparative data in series, even on the same line, is possible (where the transmission is probably performed at a different data transmission rate). Also, a "loop back type test" can be performed so that data can be sent out, returned and compared with the originally sent data.

Preferably, the data transfer line is a bidirectional data transfer line. This way, a comparatively simple setup can be used (in particular additional pins, lines and/or space can be saved). Normally, no significant performance degradation will result from this, because usually data is only transmitted in one direction at a time anyhow (as it is usually the case with computer memory and/or computer graphics memory). It should be mentioned that the transmission characteristics of a bidirectional data transfer line can be different for the two directions. Therefore, either a "compromise" setting of the equalizer can be chosen, so that "both directions are served well on the average" (where statistical considerations with respect to the ratio between sending and receiving can be taken into account as well), or different settings are used depending on the direction of the data transfer. However, the presently suggested invention can be used with unidirectional data transfer lines as well.

It is further suggested to use at least two equalizer units, wherein said two equalizer units are preferably arranged on a single side of said data transfer line. Although it is in principle possible to use a single equalizer unit and to presumably readjust it depending on the direction of the data transmission, usually a better result can be obtained if separate equalizers are used. In particular it is possible to optimise the respective equalizer (for example a transmit equalizer and a receive equalizer) for its respective task, even on the hardware side. This can result in an even higher performance. If said two equalizer units are arranged on a single side of said data transfer line, only one component has to be modified. This suggestion can prove to be very advantageous, because usually in time synchronised data transfer systems, a single master unit serves a plurality of slave units. If hence the modification of providing equalizers is performed on the master side, only a comparatively small percentage of the overall components have to be provided with additional components. This way, the overall cost usually does not increase significantly. Surprisingly, it is even possible to reduce the overall cost. This is, because the minimum standard required for the data transmission can be relaxed (because a degraded signal quality can usually be compensated by appropriately adjusted equalizers). This way, the hardware requirements of some of the components (in particular of slave components) can be reduced. This way, those devices can be produced cheaper. On the average, the net effect can be in a way that the overall arrangement is even cheaper as compared to present arrangements. In this context it should be mentioned that a higher signal quality "per se" does not pose any problem. This way, it is possible to use (just to name an example) an "improved" memory controller (that is designed according to the present suggestion), both in connection with "standard" memory chips (i.e. obeying present JEDEC-standards), but also with "inferior" memory chips (i.e. memory chips with relaxed system specifications). This possibility can increase the acceptance of the presently suggested method and system significantly.

A preferred embodiment of the method can be realised if said training phase comprises at least two training cycles, preferably at least one training cycle for a data transfer in a first direction and at least one training cycle for a data transfer in a second direction. The training cycles in this context generally relate to training cycles for adjusting the settings of equalizer units. As already mentioned, the transmission characteristics of data transmission lines usually depend on the direction of the data transfer, even when a single, bidirectional data transmission line is used. If both directions are considered during training, usually a better overall training can be achieved, thus resulting in an increased data transfer performance.

A possible embodiment of the method can be realised if said data transfer line is used at least at times for transmitting comparative data if the integrity of the data transmission is secured, at least in the respective direction. This way, it is possible to train a bidirectional data transfer line in a first step in a first direction by using a memory address line (for example) for transmitting the comparative data. After the equalizer settings for this direction have been determined and employed, one can rely on the integrity of the data transmitted on the data transmission line in this direction. Now, one can use the data transfer line as a safe data transfer line in this direction. In a second step, the settings of (usually) another equalizer for improving the data transfer characteristics in the opposite direction can be determined. For completeness it should be mentioned that the transmitted data can preferably be (temporarily) stored on both sides of the data transmission line. This way, the direction of the data transmission of the test data and the direction of the data transmission of the comparative data can point in different directions. This way, a "loopback" can be realised. However, it is of course possible as well, that both test data and comparative data are sent in the same direction.

It is possible to realise the safe transfer channel in a wide variety of ways. However, first experiments have shown that it is preferred if the safe transfer channel is realised at least at times by using an alternative data line and/or by using safe data transfer characteristics. The alternative data line can be a data line that is provided for other purposes (for example a memory address line or an error correction line or the like), or can be a line that is (essentially) reserved for transmitting comparative data. Additionally or alternatively, safe data transfer characteristics can be employed for transmitting the comparative data. As an example, a lower data transfer speed, a better signal quality (using more energy and/or producing more waste heat) or the like can be used.

It is particularly preferred if the safe transfer line is a line that is used at times for purposes of said training phase and used at times for other purposes. This way, the number of hardware lines can be reduced. In particular, a line can be used which has to be "present anyhow", for example a memory address transmission line, an error detection line or the like.

Preferably, the method is employed in a way that said training phase comprises at least one additional training cycle, in particular a phase adjusting training cycle. By the expression "additional training cycle" in particular a training cycle that is different from a training cycle for adjusting the setting of an equalizer is meant. Although a wide variety of training cycles can be considered, first experiments have shown that in particular a phase adjusting step results in a particular predominant improvement of the data transfer characteristics. In particular, it is possible to use a phase adjusting training cycle as described in European patent application with filing number EP 12174388.4, filed by the present applicant on 29. June 2012 with the European patent office. The disclosure of this application is fully incorporated into the disclosure of this application by reference.

Another preferred embodiment of the method can be realised if said training phase and/or at least one training cycle can be repeated. It is possible that the training cycle is "instantaneously" repeated (in particular after finishing a previous training cycle and/or even during the same training phase and/or immediately following a previous training phase) if a checking step reveals that no suitable data transfer performance has been established. However, the repetition can be performed "somewhat later" as well, for example if a continuous monitoring of the data transmission reveals that a degradation of the data transmission has taken place. In such a case, a "retraining" can be performed once in a while. This way, an advantageous data transfer can be sustained, even for prolonged periods of time.

In particular, the method can be used for a data transfer line that is at least at times operated with an increased data transfer rate. As an example, the data transfer rate can be performed at double, quadruple or even higher speeds, as compared to the clocking speed of the "remaining" components. In particular, such a "high speed" data transfer line is particularly prone to transmission errors; hence, an improvement of the signal integrity on such a line is particularly rewarding.

In particular, the presently suggested method can be employed for synchronising a memory controller and a memory unit, in particular of a DDR-memory type (DDR = double data rate). For such fields of application, the intrinsic features and advantages of the presently proposed methods are usually particularly predominant.

Furthermore, an equalizer unit is suggested, wherein the equalizer unit is designed and arranged in a way to perform at least at times a method according to the previous description. In such a case, the equalizer unit can show the same features and advantages, as previously described, at least in analogy. Furthermore, the equalizer unit can be modified in the sense of the previous description, at least in analogy.

Even more, an electronic device, in particular a memory controller unit and/or a memory unit is suggested, that comprises at least one equalizer unit according to the previous description and/or that is designed and arranged in a way to perform at least at times a method according to the previous description. In particular, at least a part of said electronic device can comprise one or more integrated circuits and/or can be a part of at least one integrated circuit and/or can be (at least in part) a digital device. This way, the device can show the same features and advantages, as previously described, at least in analogy. Furthermore, the electronic device can be modified in the previous sense, at least in analogy, as well.

The present invention and its advantages will become more apparent, when looking at the following description of possible embodiments of the invention, which will be described with reference to the accompanying figures, which are showing:
- Fig. 1:: the schematic circuitry of a memory system with a memory controller and a memory chip according to a first embodiment of a communication system;
- Fig. 2:: an illustration of phase shift relations and an embodiment of a training cycle for adjusting them;
- Fig. 3:: a possible embodiment of a training phase of a memory system after power up in a schematic flowchart;
- Fig. 4:: a first embodiment of a memory system with an adaptive equalizer arrangement;
- Fig. 5:: a second embodiment of a memory system with an equalizer arrangement.

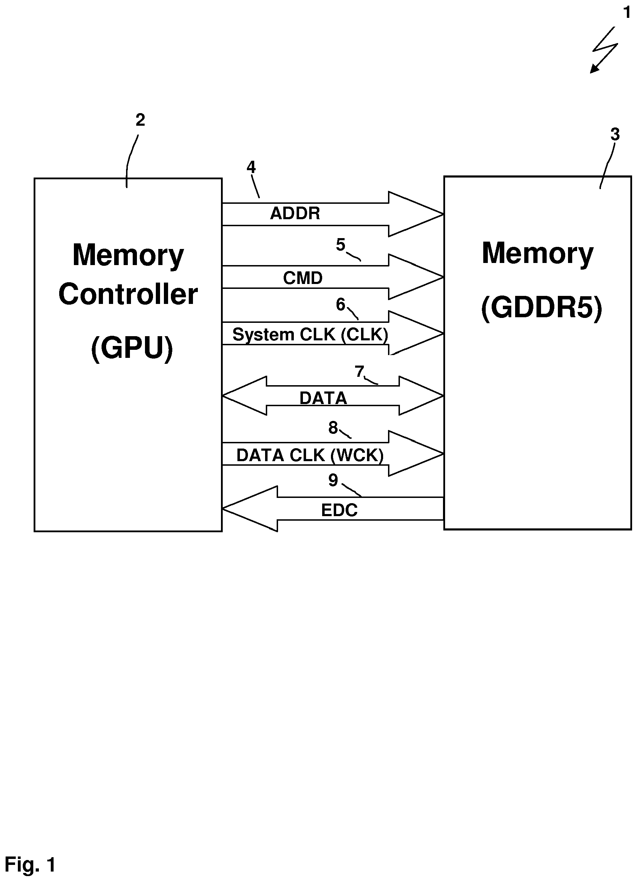

In Fig. 1 a schematic drawing of a typical example of a memory system - presently a GDDR5-system 1 - according to JEDEC-standard is shown (GDDR = graphical double data rate memory). The GDDR5-system 1 comprises a memory controller 2 (as a master) and a GDDR5-memory 3 (as a slave). The memory controller 2 and the memory 3 are connected by a variety of channels 4, 5, 6, 7, 8, 9. Some of the channels are unidirectional (channels 4, 5, 6, 8, 9) while presently one channel 7 (the data transfer line or data transfer channel) is bidirectional. In more detail, there is an address channel 4 (ADDR) for transmitting address data from the memory controller 2 to the memory 3; a command channel 5 (CMD) for transmitting commands from the memory controller 2 to the memory 3, a system clock channel 6 (CLK) for transmitting a clocking signal from the memory controller 2 to the memory 3, a data clock channel 8 (WCK) for transmitting a second clocking signal from the memory controller 2 to the memory 3, an error detection signal 9 (EDC) for transmitting error signals and phasing information from the memory 3 to the memory controller 2 and a (bidirectional) data channel 7 (DATA) for transmitting data that is read out of the memory 3/written into the memory 3 by the memory controller 2.

As implemented in the GDDR5-standard according to JEDEC specifications, the system clock 6 runs at a first frequency (for example 1 GHz). The data clock 8 runs at double frequency, i.e. presently at 2 GHz. The data on the data channel 7 is not only transmitted at a rising, but additionally at a falling flank of the data clock signal 8. Therefore data bits are transmitted on the data channel 7 at a rate of 4 GHz (i.e. at a transmission rate of 4 Gbps or 4 Giga bits per second).

Since the memory controller 2 and the memory 3 are usually from different manufacturers and sometimes of a different quality class, the signals that are transmitted between the memory controller chip 2 and the memory chips 3 are normally not perfectly adapted to each other (i.e. between the different chips). And even if a chip 2, 3 comes from the same manufacturer and is of the same quality level, part variances are inevitable, thus resulting in certain variations that can never be completely avoided.

To account for these variations, a first approach is that every part involved (in particular every chip 2, 3 from the memory system 1) has to be able to correctly handle signals with variations within a certain bandwidth. This minimum bandwidth that has to be tolerated is specified in the definition of the applicable standard (in the presently depicted case the JEDEC-standard). An example for this is the pulse width, the pulse voltage or the like.

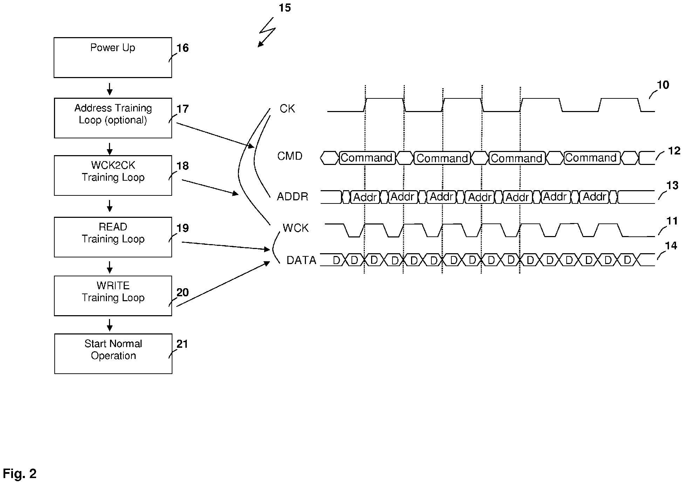

Another approach to handle these variations is to perform a training phase. Such a training phase is also implemented in the JEDEC-standard (with respect to phasing adjustments) and is schematically illustrated in Fig. 2. On the right side of Fig. 2, different clocking signals and different signals 12, 13, 14 on varying channels 4, 5, 6, 7, 8 are depicted. As can be seen, a system clocking signal 10 is transmitted at standard clocking rate on the system clock channel 6 (see Fig. 1). The system clocking signal 10 is essentially a repetitive rectangular signal at a certain frequency of presently 1 GHz. Furthermore, the data clock signal 11 on the data clock channel 8 is indicated in Fig. 2. The data clock signal 11 presently runs at double frequency as compared to the system clock signal 10. Furthermore, the command data 12 on the command channel 5, the address data 13 on the address channel 4 and the user data 14 on the data channel 7 are also indicated. As can be seen, in the presently shown embodiment of a memory system 1, a command 12 bit is transmitted on every rising flank of the system's clocking signal 10, i.e. at 1 GHz rate. An address data 13 bit is transmitted on every rising and falling flank of the system clocking signal 10, i.e. at 2 GHz data transfer rate. Lastly, a chunk of user data 14 is transmitted on every rising and falling flank of the data clock signal 11, i.e. presently at 4 GHz.

When powering up the memory system 1, the different phases of the different signals 10, 11, 12, 13, 14 are usually not very well aligned to each other. This is very problematic, because the memory system 1 is very vulnerable to phase shifts between the different signals. The vulnerability is particularly predominant for the user data 14 on data channel 7, since this signal is clocked by a different clocking signal, namely the data clock signal 11 as opposed to the system clocking signal 10.

Therefore, according to current JEDEC-specification, a phase training sequence 15 is performed immediately after powering up 16 the memory system 1.

In a first step 17 and in a second step 18 the phase shift of the address data 13 on the address channel 4 with respect to the clocking signal 10 will be adjusted, (address training 17). Thence, a WCK2CK training loop 18 will be performed, in which the phasing of the data clock signal 11 and the system clock signal 10 will be adjusted. After this step 18, the phasing of the data signal 14 is adjusted (usually with respect to the data clock signal 11). This phasing adjustment is split up into two parts, namely the read training cycle 19 and the write training cycle 20. This is due to the fact since the time delays on the data channel 7 depend on the direction of the data transmitted. This is due to different electronic components used and variation of their individual characteristics (including part variances).

According to present JEDEC-standards, after the read training cycle 19 and the write training cycle 20 the powering up training phase is completed and normal operation starts 21.

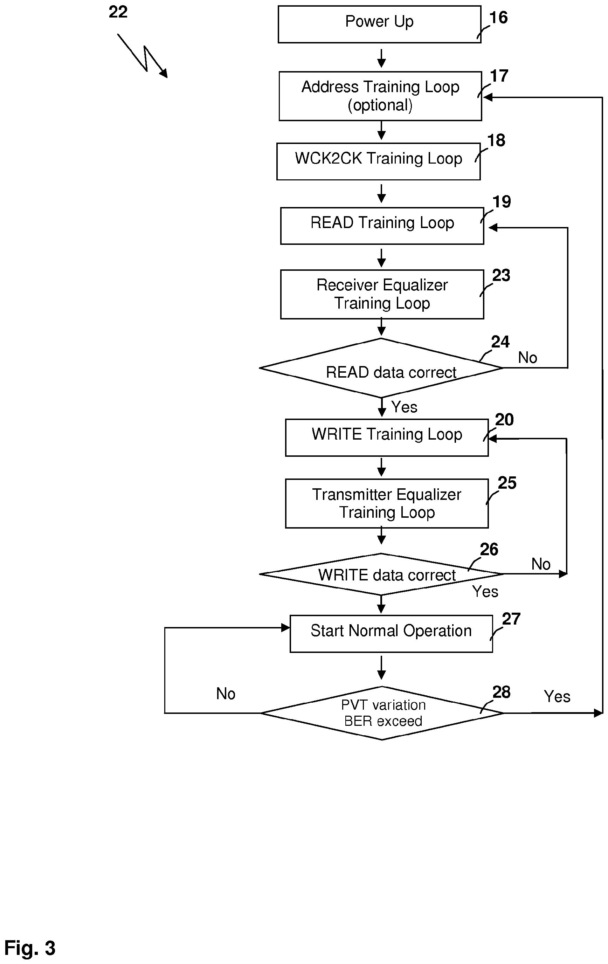

However, significantly improved results can be obtained, if an amended training phase 22 is used at start-up. A possible embodiment of such an amended training phase 22 is shown as a flowchart in Fig. 3.

After initially powering up 16 the memory system 1 (or another electronic device), an address training cycle 17 and a clock signal phasing training cycle 18 is initiated according to the amended training phase 22 (similar to the previously described phase training sequence 15). Also similar to the previously described phase training sequence 15, a read phasing training cycle 19 is initiated according to amended training phase 22.

After the phasing of the read signal 14 on the data channel 7 is completed, however, a receive equalizer training cycle 23 is interspersed. Here, the user data 14 that is transmitted via the data channel 7 is compared with the identical user data that is transferred via a safe data channel (i.e. comparative data; more explanation will follow). The setting of the receive equalizer 33 will be performed in a way so that errors between the user data 14 transmitted on the data channel 7 and the comparative data will be below a certain threshold value, preferably minimised. Whether this condition has already been achieved will be checked in a consecutive interrogation step 24. If the read data (user data 14 transmitted on data channel 7) is not yet correct, the sequence will jump back to the read training cycle 19, again followed by another receive equalizer training cycle 23, according to the amended training phase 22. These steps will be repeated, until a satisfactory low error level has been reached. Then, the read training 19, 23 will be finished and the write training 20, 25 will be initiated, by first starting with the write phasing training cycle 20 (see also the respective step in phase training sequence 15 according to Fig. 2). Once the phasing of the user data 14 on the data channel 7 in write direction is established, a transmit equalizer training cycle 25 will be performed. If a sufficiently low error rate has not been established after this step 25 (which will be checked in a write data correctness interrogation step 26), the write training 20, 25 will be repeated using write phasing training cycle 20 and transmit equalizer training cycle 25. Once a sufficiently low error level has been established, both in a read and in a write direction, normal operation will start 27.

Preferably, the error rate of the memory system 1 will be continuously monitored 28. As long as the error rate is sufficiently low, normal operation 27 will continue. If, however, a certain threshold level will be exceeded (which can occur due to temperature differences, e.g. resulting from waste heat) a preferably complete amended training phase 22 will be re-initiated. This way, a good performance of the memory system can be sustained. It should be mentioned that the percentage of training phases with respect to overall running time is normally in the low single digit percentage region (if at all that high).

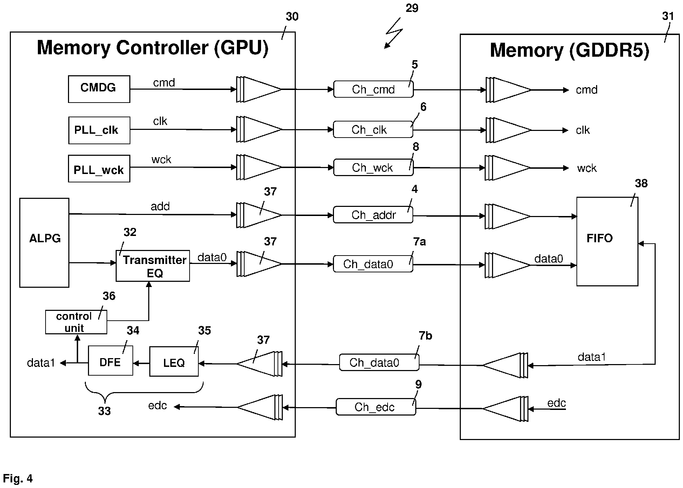

In Fig. 4, a schematic overview of a more elaborate memory system 29 with a memory controller 30 and a memory unit 31 is shown. In particular, some internal circuitries of the memory controller chip 30 and the memory chip 31 are additionally shown, while the different lines 4 to 9 that are interconnecting memory controller chip 30 and memory chip 31 are similar to the different channels 4 to 9, shown in Fig. 1. However, for illustrative purposes, the bidirectional data channel 7 is graphically split up into separate lines 7a, 7b (logical directional lines) in Fig. 4. However, this is only done for illustrative purposes, thus representing the two different logical data transmission directions of the data channel line 7. Physically, the data channel 7 is a single, bidirectional data channel.

As indicated in the flowchart of the amended training phase 22, shown in Fig. 3, a transmit equalizer 32 and a receive equalizer 33 that is presently comprised of a non-linear equalizer 34 (usually known as a DFE = decision feedback equalizer) and a linear equalizer 35 (commonly known as LEQ = linear equalizer) is provided. Furthermore, a control unit 36 is provided for controlling both the transmit equalizer 32 and the receive equalizer 33. Furthermore, a variety of amplifiers 37 is present both in the memory controller chip 30 as well as in the memory chip 31. Furthermore, a memory unit 38 is indicated within memory chip 31. The memory unit 38 is of a so-called FIFO-type (FIFO = first in first out). In the memory unit 38 data can be temporarily stored, in particular user data transmitted via the data channel 7, as well as comparative data, transmitted (in the presently shown embodiment) on the address channel 4. These two chunks of data can then be compared with each other.

The receive equalizer training cycle 23 (see Fig. 3) is performed in a way that test data is transmitted via the address channel 4. This can be implemented by first sending a certain command, for example via the command channel 5, indicating that for the time being test data (and no user data) is transmitted via the address channel 4. This test data is temporarily stored in memory unit 38. This temporal storage is necessary, since the transmission rate on the address channel 4 is lower as compared to the transmission rate of the data channel 7 (in particular 7b). Since the address channel 4 runs at a lower speed, the transmission can be considered to be reliable i.e. to be essentially error free. Of course, the test data transmitted on the address channel 4 is not only stored in memory unit 38, but also buffered in control unit 36. Once the memory unit 38 has stored a certain amount of data, the test data will be transmitted through the data channel 7 (in direction from memory chip 31 to memory controller chip 30, i.e. on "logical data channel 7b"). Now the looped back test data is compared with the test data buffered in control unit 36. Due to the characteristics of the different transmission channels 4, 7, it is assumed that any error that is present comes from the transmission via "logical data channel 7b". Hence, receive equalizer 33 is adapted by controller unit 36 in a way that the error rate will be set below a certain threshold value, preferably minimised (see read data correctness interrogation step 24 in Fig. 3).

Now after training of the "logical read data channel 7b", this data channel is considered to be "safe" in this direction (i.e. essentially error free). Now, the second training cycle is initiated starting with a write phasing training cycle 20, and followed by a transmit equalizer 32 training cycle 25. In the latter, data is generated and transmitted by the control unit 36 towards the memory chip 31 through "logical data channel 7a". The data, received by the memory chip 31 is directly sent back through a "logical read data channel 7b" (in reality a short buffering has to occur to avoid collisions). Since the "logical read data channel 7b" is considered to be error free, it is assumed that all errors occurring are induced by the "logical write data channel 7a". Based on this assumption, the transmit equalizer 32 is set up in a way by controller unit 36 to bring the error level below a certain threshold (which can be the same threshold as in the read case or a different threshold), preferably minimised.

Once both read and write training cycles are completed, the memory system 29 is ready for operation.

Although the training phase was described with respect to a memory system 29, using certain types of equalizers 32, 33, 34, 35, it is clear that the suggestions made can be used for different time synchronised data transfer systems as well. Furthermore, other types of equalizers can be used. In effect, essentially all types of equalizers that are known in the state of the art can be used in connection with the present invention. Therefore, for brevity no specific embodiment of a possible transmit equalizer and/or receive equalizer is given (and needs to be given).

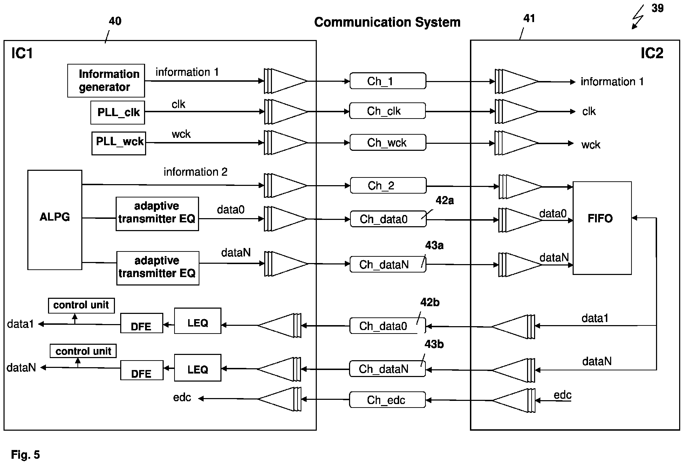

In Fig. 5, a modified memory system 39 (which can be a different type of communication system as well) according to another embodiment is schematically shown. Similar to the embodiment 29 shown in Fig. 4, a memory controller chip 40 is connected to a memory chip 41. However, the data channel not only consists of a single data line 7, but instead of a plurality of data lines 42, 43 (which are again split up "logically" in the two different directions a, b for illustrative purposes, although they are physically bidirectional data lines 42, 43). According to the embodiment shown in Fig. 5, the training phases for the different data lines 42, 43 can be performed in series, one after another. The advantage of this embodiment is that a reduced amount of electronic devices is needed for this embodiment of a training phase. As a drawback, the training phase will take more time to complete. However, since training phases usually account for an only minor percentage of the total runtime, this is normally of no or only minor relevance.

However, the memory system (communication system) according to Fig. 5 can be designed in a different way as well, in particular in a way that the training phases for the different data lines 42, 43 are performed in parallel to reduce the overall training time for all data lines 42, 43. The drawback of such a modified embodiment is the increased amount of electronic devices necessary. This increased amount of electronic devices can be reduced, if a transmitter/receiver pair of equalizers can be used for two or even more nearby data lines in granularity of 2 or more which have approximately the same (or at least similar) characteristics.

**Reference list**

| | | | |
|---|---|---|---|
| 1. | GDDR5-system | 26. | write data correctness interrogation |
| 2. | memory controller | | |
| 3. | GDDR5-memory | 27. | start of normal operation |
| 4. | address channel | 28. | monitoring of error rate |
| 5. | command channel | 29. | memory system |
| 6. | system clock channel | 30. | memory controller |
| 7. | data channel | 31. | memory chip |
| 8. | data clock channel | 32. | transmit equalizer |
| 9. | error detection signal channel | 33. | receive equalizer |
| | | 34. | non-linear equalizer |
| 10. | system clock signal | 35. | linear equalizer |
| 11. | data clock signal | 36. | control unit |
| 12. | command data | 37. | amplifier |
| 13. | address data | 38. | memory unit |
| 14. | user data | 39. | modified memory system |
| 15. | phase training sequence | 40. | memory controller |
| 16. | power up | 41. | memory chip |
| 17. | address phase training cycle | 42. | data channel |
| | | 43. | data channel |
| 18. | clock signal phase training cycle | | |
| 19. | read phasing training cycle | | |
| 20. | write phasing training cycle | | |
| 21. | start of normal operation | | |
| 22. | amended training phase | | |
| 23. | receive equalizer training cycle | | |
| 24. | read data correctness interrogation | | |
| 25. | transmit equalizer training cycle | | |

## Claims

1. Method (22) for improving the signal integrity of a data transfer line (7, 42, 43) in a time synchronised data transfer system (1, 29, 39), wherein at least one equalizer unit (32, 33, 34, 35) is provided for said data transfer line (7, 42, 43), wherein a training phase (15, 22) is used, comprising at least one training cycle (23, 25) for adjustment of the settings of said at least one equalizer unit (32, 33, 34, 35), **characterised in that** said adjustment of the settings of said at least one equalizer unit (32, 33, 34, 35) is at least in part based on transmitting test data via said data transfer line (7, 42, 43) to be trained and comparing said test data with comparative data that is transferred via a safe transmission channel (4, 5) that has few errors, as compared to the error rate of test data on the said data transfer line (7, 42, 43) to be trained.

2. Method (22) according to claim 1, **characterised in that** said at least one equalizer unit (32, 33, 34, 35) alters the voltage level and/or the signal shape and/or the duty cycle of the data signal on said data transfer line (7, 42, 43).

3. Method (22) according to claim 1 or 2, **characterised in that** said test data and/or said comparative data is at least at times stored (38).

4. Method (22) according to any of the preceding claims, **characterised in that** said data transfer line (7, 42, 43) is a bidirectional data transfer line (7, 42, 43).

5. Method (22) according to claim 4, **characterised in that** at least two equalizer units (32, 33, 34, 35) are used.

6. Method (22) according to claim 4 or 5, **characterised in that** said training phase (15, 22) comprises at least one training cycle (23) for a data transfer in a first direction (7b, 42b, 43b) and at least one training cycle (25) for a data transfer in a second direction (7a, 42a, 43a).

7. Method (22) according to claim 6, **characterised in that** said data transfer line (7, 42, 43) is used, at least at times, for transmitting comparative data if the integrity of the data transmission is secured, at least in the respective direction (7a, 42a, 43a).

8. Method (22) according to any of the preceding claims, **characterised in that** a safe transfer channel (4, 5, 7a, 42a, 43a) is realised at least at times by using an alternative data line (4, 5) and/or by using safe data transfer characteristics.

9. Method (22) according to any of the preceding claims, **characterised in that** the safe transfer line (4, 5) is a line that is used at times for purposes of said training phase and used at times for other purposes (12, 13).

10. Method (22) according to any of the preceding claims, **characterised in that** said training phase (15, 22) comprises at least one additional training cycle (17, 18, 19, 20), in particular a phase adjusting training cycle (17, 18, 19, 20).

11. Method (22) according to any of the preceding claims, **characterised in that** said training phase (15, 22) and/or at least one training cycle (17, 18, 19, 20, 23, 25) can be repeated (24, 26, 28).

12. Method (22) according to any of the preceding claims, **characterised in that** the data transfer line (7, 42, 43) is at least at times a data transfer line with an increased data transfer rate (7, 42, 43).

13. Method (22) according to any of the preceding claims, **characterised in that** it is used for synchronising a memory controller (30, 40) and a memory unit (31, 41).

14. Equalizer unit (32, 33, 34, 35), **characterised in that** the equalizer unit is designed and adapted to perform at least at times a method (22) according to any of the preceding claims 1 to 13.

15. Digital device (1, 29, 39), comprising at least one equalizer unit (32, 33, 34, 35) according to claim 14.

## Patentansprüche

1. Verfahren (22) zur Verbesserung der Signalintegrität einer Datenübertragungsleitung (7, 42, 43) in zeitsynchronen Datenübertragungssystemen (1, 29, 39), wobei für die besagte Datenübertragungsleitung (7, 42, 43) mindestens ein Equalizer (32, 33, 34, 35) zur Verfügung steht, eine Lernphase (15, 22) für die Änderung der Einstellungen mindestens eines Equalizers (32, 33, 34, 35) vorgesehen ist, diese Änderung der Einstellungen mindestens eines Equalizers (32, 33, 34, 35) zumindest teilweise auf der Übertragung von Prüfdaten über die besagte zu trainierende Datenübertragungsleitung (7, 42, 43) erfolgt und die Prüfdaten mit Vergleichsdaten abgeglichen werden, die über einen sicheren Übertragungskanal (4, 5) übermittelt werden, der im Vergleich zur besagten zu trainierenden Datenübertragungsleitung (7, 42, 43) eine niedrigere Fehlerquote aufweist.

2. Verfahren (22) nach Anspruch 1 **dadurch gekennzeichnet, dass** mindestens einer der besagten Equalizer (32, 33, 34, 35) das Spannungsniveau, die Signalform und/oder die Einschaltdauer der besagten Datenübertragungsleitung (7, 42, 43) verändert.

3. Verfahren (22) nach Anspruch 1 oder 2 **dadurch gekennzeichnet, dass** die besagten Prüfdaten oder Vergleichsdaten zumindest zeitweise gespeichert werden (38).

4. Verfahren (22) nach einem der vorangegangenen Ansprüche **dadurch gekennzeichnet, dass** es sich bei der besagten Datenübertragungsleitung (7, 42, 43) um eine bidirektionale Datenübertragungsleitung (7, 42, 43) handelt.

5. Verfahren (22) nach Anspruch 4 **dadurch gekennzeichnet, dass** mindestens zwei Equalizer (32, 33, 34, 35) eingesetzt werden.

6. Verfahren (22) nach Anspruch 4 oder 5 **dadurch gekennzeichnet, dass** die besagte Lernphase (15, 22) mindestens einen Trainingszyklus (23) für eine Datenübertragung in eine erste Richtung (7b, 42b, 43b) und mindestens einen Trainingszyklus (25) für eine Datenübertragung in eine zweite Richtung (7a, 42a, 43a) umfasst.

7. Verfahren (22) nach Anspruch 6 **dadurch gekennzeichnet, dass** die besagte Datenübertragungsleitung (7, 42, 43) mindestens zeitweise für die Übertragung von Vergleichsdaten zumindest in die jeweilige Richtung (7a, 42a, 43a) genutzt wird, sofern die Integrität der Datenübermittlung sichergestellt ist.

8. Verfahren (22) nach einem der vorangegangenen Ansprüche **dadurch gekennzeichnet, dass** ein sicherer Übertragungskanal (4, 5, 7a, 42a, 43a) zumindest zeitweise durch die Nutzung alternativer Datenleitungen (4, 5) oder die Verwendung sicherer Datenübermittlungseigenschaften realisiert wird.

9. Verfahren (22) nach einem der vorangegangenen Ansprüche **dadurch gekennzeichnet, dass** die sichere Übertragungsleitung (4, 5) mal für die besagte Lernphase, mal für andere Zwecke (12,13) genutzt wird

10. Verfahren (22) nach einem der vorangegangenen Ansprüche **dadurch gekennzeichnet, dass** die besagte Lernphase (15, 22) mindestens einen weiteren Trainingszyklus (17,18, 19, 20) und insbesondere einen Trainingszyklus (17,18, 19, 20) zur Phasenanpassung umfasst.

11. Verfahren (22) nach einem der vorangegangenen Ansprüche **dadurch gekennzeichnet, dass** die besagte Lernphase (15, 22) oder mindestens ein Trainingszyklus (17,18, 19, 20, 23, 25) wiederholt werden kann (24, 26, 28).

12. Verfahren (22) nach einem der vorangegangenen Ansprüche **dadurch gekennzeichnet, dass** es sich bei der Datenübertragungsleitung (7, 42, 43) mindestens zeitweise um eine Datenübertragungsleitung (7, 42, 43) mit erhöhter Datenübertragungsrate handelt.

13. Verfahren (22) nach einem der vorangegangenen Ansprüche **dadurch gekennzeichnet, dass** diese für die Synchronisierung einer Speichersteuerung (30, 40) und einer Speichereinheit (31, 41) genutzt wird.

14. Ein Equalizer (32, 33, 34, 35), der so konstruiert und eingestellt ist, dass er zumindest zeitweise die Verfahren (22) nach einem der vorangegangenen Ansprüche 1 bis 13 ausführen kann.

15. Digitalgerät (1, 29, 39), das mindestens einen Equalizer (32, 33, 34, 35) nach Anspruch 14 umfasst.

## Revendications

1. Méthode (22) visant à améliorer l'intégrité des signaux d'une ligne de transmission de données (7, 42, 43) dans un système de transmission de données synchrone (1, 29, 39), système dans lequel est fourni au moins un égaliseur (32, 33, 34, 35) pour ladite ligne de transmission de données (7, 42, 43) et auquel est appliquée une phase d'essai (15, 22), comprenant au moins un cycle d'essai (23, 25) dans le but de régler les paramètres d'au moins un égaliseur (32, 33, 34, 35), **caractérisée par le fait que** ledit réglage des paramètres dudit égaliseur (32, 33, 34, 35) est du moins en partie basé sur la transmission des données testées via ladite ligne de transmission de données (7, 42, 43) soumises à essai et sur la comparaison des dites données testées avec des données comparatives qui sont transmises via un canal de transmission sécurisé (4, 5) qui présente peu d'erreurs, comparé au taux d'erreur des données testées sur ladite ligne de transmission de données (7, 42, 43) soumise à essai.

2. Méthode (22) concernant la demande 1, **caractérisée par le fait qu'**au moins un égaliseur (32, 33, 34, 35) modifie le niveau de tension et/ou la forme du signal et/ou le cycle de fonctionnement du signal de données sur la dite ligne de transmission de données (7, 42, 43).

3. Méthode (22) concernant les demandes 1 ou 2, **caractérisée par le fait que** lesdites données testées et/ou lesdites données comparatives sont au moins stockées à différentes périodes (38).

4. Méthode (22) concernant n'importe laquelle des demandes précédentes, **caractérisée par le fait que** ladite ligne de transmission de données (7, 42, 43) est une ligne de transmission de données bidirectionnelle (7, 42, 43).

5. Méthode (22) concernant la demande 4, **caractérisée par le fait qu'**au moins deux égaliseurs (32, 33, 34, 35) sont utilisés.

6. Méthode (22) concernant la demande 4 ou 5, **caractérisée par le fait que** ladite phase d'essai (15, 22) comprend au moins un cycle d'essai (23) pour la transmission des données dans une première direction (7b, 42b, 43b) et au moins un cycle d'essai (25) pour la transmission des données dans une seconde direction (7a, 42a, 43a).

7. Méthode (22) concernant la demande 6, **caractérisée par le fait que** ladite ligne de transmission de données (7, 42, 43) est utilisée, du moins par périodes, pour transmettre des données comparatives à condition que l'intégrité de la transmission des données soit assurée, au moins dans la direction correspondante (7a, 42a, 43a).

8. Méthode (22) concernant n'importe laquelle des demandes précédentes, **caractérisée par le fait qu'**un canal de transmission sécurisé (4, 5, 7a, 42a, 43a) est constitué, du moins par périodes, grâce à l'utilisation d'une ligne de données alternatives (4, 5) et/ou à l'utilisation de caractéristiques de transmission de données sécurisées.

9. Méthode (22) concernant n'importe laquelle des demandes précédentes, **caractérisée par le fait que** la ligne de transmission sécurisée (4, 5) est une ligne qui est utilisée, par périodes, pour servir ladite phase d'essai (15, 22) et, par périodes, à d'autres fins (12,13).

10. Méthode (22) concernant n'importe laquelle des demandes précédentes, **caractérisée par le fait que** ladite phase d'essai (15, 22) comprend au moins un cycle d'essai supplémentaire (17, 18, 19, 20), en particulier un cycle d'essai pour le réglage des paramètres (17, 18, 19, 20).

11. Méthode (22) concernant n'importe laquelle des demandes précédentes, **caractérisée par le fait que** ladite phase d'essai (15, 22) et/ou au moins un cycle d'essai (17, 18, 19, 20, 23, 25) peuvent être répétés (24, 26, 28).

12. Méthode (22) concernant n'importe laquelle des demandes précédentes, **caractérisée par le fait que** la ligne de transmission de données (7, 42, 43) est, du moins à certaines périodes, une ligne de transmission de données présentant un taux accru de transmission de données (7, 42, 43).

13. Méthode (22) concernant n'importe laquelle des demandes précédentes, **caractérisée par le fait qu'**elle est utilisée pour la synchronisation d'un contrôleur de mémoire (30, 40) et d'une unité de mémoire (31, 41).

14. Egaliseur (32, 33, 34, 35), **caractérisé par le fait que** l'égaliseur est conçu et adapté pour exécuter, du moins à certaines périodes, une méthode (22) concernant n'importe laquelle des demandes précédentes de 1 à 13.

15. Appareil numérique (1, 29, 39), comprenant au moins un égaliseur (32, 33, 34, 35) concernant la demande 14.
